(19) Europäisches Patentamt
European Patent Office
Office européen des brevets

(11) **EP 3 011 567 B1**

(12) **EUROPÄISCHE PATENTSCHRIFT**

(45) Veröffentlichungstag und Bekanntmachung des Hinweises auf die Patenterteilung:
**16.10.2019   Patentblatt 2019/42**

(51) Int Cl.:
**G11C 13/00** (2006.01)   **G11C 14/00** (2006.01)
**G11C 11/56** (2006.01)

(21) Anmeldenummer: **14729580.2**

(22) Anmeldetag: **17.05.2014**

(86) Internationale Anmeldenummer:
**PCT/DE2014/000257**

(87) Internationale Veröffentlichungsnummer:
**WO 2014/202038 (24.12.2014 Gazette 2014/52)**

(54) **NICHTFLÜCHTIGE, KAPAZITIV AUSLESBARE SPEICHERELEMENTE**

NONVOLATILE, CAPACITIVELY READABLE MEMORY ELEMENTS

ÉLÉMENTS DE MÉMOIRE NON VOLATILS À LECTURE CAPACITIVE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.06.2013   DE 102013010411**
**19.02.2014   DE 102014002288**

(43) Veröffentlichungstag der Anmeldung:
**27.04.2016   Patentblatt 2016/17**

(73) Patentinhaber:
• **Forschungszentrum Jülich GmbH**
**52425 Jülich (DE)**
• **Rheinisch-Westfälische Technische Hochschule Aachen (RWTH)**
**52062 Aachen (DE)**

(72) Erfinder:
• **TAPPERTZHOFEN, Stefan**
**40221 Düsseldorf (DE)**
• **LINN, Eike**
**52146 Würselen (DE)**
• **NIELEN, Lutz**
**52064 Aachen (DE)**
• **WASER, Rainer**
**52076 Aachen (DE)**
• **VALOV, Ilia**
**52066 Aachen (DE)**

(56) Entgegenhaltungen:
WO-A1-2010/136056   WO-A2-2010/014974
US-A1- 2006 120 138   US-A1- 2007 035 990
US-A1- 2009 225 584   US-A1- 2011 305 065
US-A1- 2012 243 293

**Beschreibung**

Die Erfindung betrifft nichtflüchtige, kapazitiv auslesbare Speicherelemente zur Durchführung eines Verfahrens zum kapazitiven Auslesen resistiver Speicherelemente.

Stand der Technik

Passive resistive Speicherzellen sind im Vergleich zu ladungsbasierten Speichern, wie etwa Flash-Speichern, einfach aufgebaut und daher bei gegebener minimaler Featuregröße F auf der idealen Fläche von $4F^2$ realisierbar. In einem großen Array aus vielen solcher Speicherzellen fließen Ströme jedoch nicht nur durch die gerade angesprochene Speicherzelle, sondern es gibt auch parasitäre Strompfade durch nicht angesprochene Speicherzellen. Dies ist ein begrenzender Faktor für die maximal realisierbare Arraygröße.

Aus dem deutschen Patent 10 2009 023 153 ist bekannt, ein resistiv schaltendes Speicherelement als antiserielle Schaltung aus zwei Speicherzellen auszubilden. Jedes solche Speicherelement bildet unabhängig von seinem Zustand (0 oder 1) in parasitären Strompfaden einen hochohmigen Widerstand. Es ist nur kurzzeitig niederohmig, wenn es im Zustand 1 gezielt angesprochen und von einem Lesestrom durchsetzt wird. Damit werden auch große Arrays aus vielen Speicherelementen realisierbar. Dies wird damit erkauft, dass das Auslesen einer 1 destruktiv ist und die 1 nach dem Auslesen wieder in das Speicherelement zurückgeschrieben werden muss.

Das deutsche Patent 10 2011 012 738 stellt ein Verfahren zur Verfügung, mit dem derartige Speicherelemente nichtdestruktiv ausgelesen werden können. Voraussetzung hierfür ist, dass die Speicherzellen, die ein Speicherelement bilden, unterschiedlich gefertigt sind, so dass sie sich in einer Reihenschaltung über unterschiedliche Beiträge zu einer elektrischen Eigenschaft dieser Reihenschaltung voneinander unterscheiden lassen. Nachteilig ist diese Art der Fertigung technologisch anspruchsvoll und verschlechtert die Symmetrie des Schaltverhaltens derartiger Speicherelemente.

Die amerikanische Patentanmeldung US2007/0035990 A1 offenbart eine Speichermatrix in der jede resistive Speicherzelle mit einem kapazitiven Element in Reihe geschaltet ist.

Die amerikanische Patentanmeldung US2006/0120138 A1 offenbart einen Halbleiterspeicher mit einem DRAM-Speicherelement welches elektrisch an ein nicht-flüchtiges resistives Polymer-Speicherelement elektrisch gekoppelt ist.

Aufgabe und Lösung

Aufgabe der Erfindung ist es, nichtflüchtige Speicherelemente zur Verfügung zu stellen, die sich zur Durchführung eines Verfahrens zum nichtdestruktiven Auslesen eignen und die zugleich technologisch einfach herzustellen sind.

Diese Aufgaben werden erfindungsgemäß gelöst durch ein nichtflüchtiges, nichtdestruktiv kapazitiv auslesbares Speicherelement gemäß Hauptanspruch 1. Weitere vorteilhafte Ausgestaltungen ergeben sich aus den darauf rückbezogenen Unteransprüchen 1 und 2.

Gegenstand der Erfindung

Im Rahmen der Erfindung wurde ein Verfahren zum Auslesen eines nichtflüchtigen Speicherelements mit mindestens zwei stabilen Zuständen 0 und 1 entwickelt. Dieses umfasst mindestens eine resistive Speicherzelle, die die beiden Zustände 0 und 1 in einen Zustand HRS mit höherem elektrischem Widerstand und einen Zustand LRS mit niedrigerem elektrischem Widerstand kodiert. Das Speicherelement weist in den beiden Zuständen 0 und 1 unterschiedliche Kapazitäten $C_{0,1}$ auf; über diesen Unterschied wird bestimmt, welcher Zustand vorliegt.

Erfindungsgemäß wird ein Speicherelement gewählt, in dem eine vom Zustand der Speicherzelle unabhängige Festkapazität mit der Speicherzelle in Reihe geschaltet ist. Die Gesamtkapazität $C_{0,1}$ des Speicherelements setzt sich dann je nach Zustand 0 oder 1 der Speicherzelle in unterschiedlicher Weise aus der Kapazität $C_R$ der Speicherzelle und der Festkapazität $C_F$ zusammen: Ist die Speicherzelle niederohmig (Zustand 1), überbrückt dieser geringe Widerstand die Kapazität $C_R$ der Speicherzelle, so dass allein $C_F$ maßgeblich ist:

$$C_1 = C_F.$$

Ist die Speicherzelle dagegen hochohmig (Zustand 0), gilt

$$C_0 = \frac{C_F \cdot C_R}{C_F + C_R}.$$

Es wurde erkannt, dass eine Reihenschaltung einer resistiven Speicherzelle mit einer Festkapazität statt mit einer zweiten resistiven Speicherzelle die Signalstärke beim kapazitiven Auslesen gemäß dem deutschen Patent 10 2011 012 738 verbessert. Gemäß diesem Patent sind zwei Speicherzellen A und B zu einem Speicherelement in Reihe geschaltet, wobei immer eine der Speicherzellen hochohmig und die andere niederohmig ist (Zustandskombination A1 und B0 bzw. A0 und B1). Damit diese Zustände beim kapazitiven Auslesen voneinander unterschieden werden können, ist es notwendig, dass sich die beiden Speicherzellen A und B in ihren Kapazitäten hinreichend voneinander unterscheiden. Dies steht im Widerspruch dazu, dass beide Zellen elektrisch möglichst identisch sein sollten, damit das Speicherelement als Ganzes ein möglichst symmetrisches Schaltverhalten aufweist. Eine Festkapazität, die mit einer einzelnen resistiven Speicherzelle in Reihe geschaltet wird, unterliegt diesem Zielkonflikt nicht. Sie kann sich daher sehr stark von der Kapazität der Speicherzelle unterscheiden.

Es wurde außerdem erkannt, dass die zweite Speicherzelle für die Speicherfunktion entbehrlich wird, wenn das kapazitive Ausleseverfahren verwendet wird. Sie wurde ursprünglich in die Speicherelemente gemäß dem deutschen Patent 10 2009 023 153 eingeführt, um beim Auslesen mit einem Lesestrom durch das Speicherelement einen hochohmigen Widerstand für parasitäre Strompfade durch nicht adressierte Speicherelemente in einer Matrix zu bieten. Wird kapazitiv ohne Lesestrom ausgelesen, kommt es hierauf nicht mehr an. Indem nun eine Festkapazität deutlich einfacher und kompakter zu realisieren ist als eine zweite Speicherzelle, kann die gleiche Information auf kleinerem Raum zu kleineren Kosten gespeichert werden, ohne dass das Problem der parasitären Strompfade zurückkehrt.

Vorteilhaft unterscheiden sich die Festkapazität und die Kapazität der Speicherzelle im Zustand mit höherem elektrischem Widerstand mindestens um einen Faktor 3, bevorzugt mindestens um einen Faktor 5 und ganz besonders bevorzugt mindestens um einen Faktor 10 voneinander, um beim kapazitiven Auslesen ein optimales Signal zu liefern.

Alternativ kann aber auch ein nichtflüchtiges Speicherelement gewählt werden, das eine antiserielle Reihenschaltung zweier resistiver Speicherzellen A und B ist. Der Zustand 0 ist dann in der Zustandskombination A=LRS, B=HRS und der Zustand 1 in der Zustandskombination A=HRS, B=LRS kodiert. Insbesondere können sich entsprechend dem deutschen Patent 10 2011 012 738 die Kapazitäten der Speicherzellen A und B im Zustand HRS voneinander unterscheiden. Das Speicherelement kann auch einen dritten stabilen Zustand ON aufweisen, der in der Zustandskombination A=LRS, B=LRS kodiert ist.

Im Rahmen der Erfindung wurde ein nichtflüchtiges Speicherelement mit mindestens zwei stabilen Zuständen 0 und 1 entwickelt, das sich besonders zur Durchführung des erfindungsgemäßen Verfahrens eignet. Dieses Speicherelement umfasst

- mindestens eine resistive Speicherzelle, die die beiden Zustände 0 und 1 in einen Zustand HRS mit höherem elektrischem Widerstand und einen Zustand LRS mit niedrigerem elektrischem Widerstand kodiert, oder
- mindestens eine antiserielle Reihenschaltung zweier derartiger resistiver Speicherzellen A und B, die den Zustand 0 in der Zustandskombination A=LRS, B=HRS und den Zustand 1 in der Zustandskombination A=HRS, B=LRS kodiert.

Eine vom Zustand der Speicherzelle bzw. der antiseriellen Reihenschaltung unabhängige Festkapazität ist mit der Speicherzelle bzw. der antiseriellen Reihenschaltung in Reihe geschaltet.

Erfindungsgemäß umfasst die Festkapazität das Gatedielektrikum eines Feldeffekttransistors. Dieser Feldeffekttransistor kann insbesondere ein MOSFET oder der Speichertransistor eines Flash- oder EEPROM-Speichers sein. Beispielsweise kann auf das Gatedielektrikum, das den halbleitenden Kanal des Transistors bedeckt, an Stelle eines metallischen Gates die resistive Speicherzelle aufgebracht werden. Das Speicherelement hat den Vorteil, dass der Feldeffekttransistor zugleich als Ansteuerelektronik und als sehr empfindliche Ausleseelektronik für die Speicherzelle fungiert:

Bei gegebener Steuerspannung $V_{GS}$ zwischen Gate und Source ist der Drainstrom $I_D$ gegeben durch

$$I_D = \frac{K}{2} \cdot \left(V_{GS} - V_{th}\right)^2,$$

worin K der Entwurfsparameter ist, der bei der Herstellung eingestellt werden kann und von der Geometrie des Transistors abhängt. $V_{th}$ ist die Schwellspannung des Transistors. Wechselt die Speicherzelle und damit auch das Speicherelement vom Zustand 0 in den Zustand 1, wird die an der Speicherzelle angelegte Gatespannung $V_{GS}$ durch den Spannungsteiler aus Speicherzelle und Festkapazität anders aufgeteilt. Dadurch ändert sich die Schwellspannung $V_{th}$ um einen Betrag

$$\Delta V_{th} = V_{GS} \cdot \left(\frac{C_F}{C_F + C_R}\right).$$

Da die Schwellspannung quadratisch in den Drainstrom $I_D$ eingeht, reagiert der Drainstrom sehr empfindlich auf die Änderung der Gesamtkapazität und damit auf das Umschalten der Speicherzelle, das diese Änderung bewirkt hat.

Das Gatedielektrikum, das die Festkapazität $C_F$ bereitstellt, kann in herkömmlicher Weise ausgestaltet sein, so dass bis auf den Ersatz des metallischen Gates durch die Speicherzelle am Herstellungsprozess des Feldeffekttransistors nichts geändert werden muss. Es kann sogar für die Herstellung der Speicherzelle die gleiche Strukturierungsmaske wie für die bisherige metallische Gateelektrode verwendet werden, da die resistive Speicherzelle in ihrer einfachsten Form eine Schichtanordnung aus drei dünnen Lagen (untere Elektrode, Isolator, obere Elektrode) ist.

Im Gegensatz zu Speichertransistoren von EEPROM- oder Flash-Speichern muss aber das Gatedielektrikum nicht dafür ausgelegt sein, dass die auf dem Floating Gate gespeicherte Ladung für lange Zeit erhalten bleibt. Es muss also nicht für die Nichtflüchtigkeit sorgen, die erfindungsgemäß bereits in der resistiven Speicherzelle steckt. Dadurch kann das Gatedielektrikum dünner ausgestaltet werden, so dass bereits bei geringeren Schreibspannungen Elektronen durch das Dielektrikum tunneln und einen Strompuls durch die Speicherzelle treiben können, der diese umschaltet.

Damit die resistive Speicherzelle umgeschaltet werden kann, muss das Gatedielektrikum leckstrombehaftet sein. Dies bringt es mit sich, dass der Leckstrom $I_G$ zwischen Gate und Source vom gespeicherten Zustand der resistiven Speicherzelle abhängt. Befindet sich diese im Zustand LRS, ist der Leckstrom groß; befindet sie sich im Zustand HRS, ist der Leckstrom klein. Dies steht im Widerspruch zum üblichen Ziel bei der Entwicklung von Transistoren, den Leckstrom $I_G$, der sowohl den Stromverbrauch als auch die Wärmeentwicklung erhöht, zu minimieren.

Daher ist die Ausgestaltung, in der statt einer einzelnen resistiven Speicherzelle eine antiserielle Reihenschaltung zweier derartiger Speicherzellen A und B mit dem Gatedielektrikum des Feldeffekttransistors in Reihe geschaltet ist, besonders vorteilhaft. Da diese antiserielle Reihenschaltung als Ganzes immer hochohmig ist, ist der beim Lesen fließende Strom $I_G$ immer gering und außerdem unabhängig davon, ob das Speicherelement sich im Zustand 0 oder 1 befindet. Dies gilt selbst dann, wenn das Gatedielektrikum völlig weggelassen wird, d.h. wenn auf dem Kanal des Feldeffekttransistors an Stelle des bisherigen Gatestacks aus Gatedielektrikum und Gateelektrode unmittelbar die antiserielle Reihenschaltung angeordnet ist.

Dieser Vorteil des geringen Lesestroms kann aber alternativ auch eingetauscht werden gegen die Möglichkeit, auf der gleichen Fläche mehr als 1 Bit Information zu speichern. Die antiserielle Reihenschaltung und damit auch das Speicherelement weist dann einen dritten stabilen Zustand ON auf, der in der Zustandskombination A=LRS, B=LRS kodiert ist. Es ist dann zwar ein Gatedielektrikum notwendig, doch führt dies nicht zu einem erhöhten Platzbedarf.

Der Unterschied in den Kapazitäten, die das Speicherelement als Ganzes in den Zuständen 0 und 1 aufweist, kann durch eine unterschiedliche Fertigung der Speicherzellen A und B entsprechend dem deutschen Patent 10 2011 012 738 maßgeschneidert werden. Ist dagegen nur eine einzelne resistive Speicherzelle mit dem Gatedielektrikum in Reihe geschaltet, kann deren Kapazität nur insgesamt durch den Wechsel in den Zustand HRS zugeschaltet bzw. durch den Wechsel in den Zustand LRS weggeschaltet werden. Die Kapazität des Gatedielektrikums ist durch die Herstellungstechnologie des Feldeffekttransistors im Wesentlichen festgelegt.

Eine antiserielle Reihenschaltung bietet darüber hinaus mehr Freiheitsgrade für eine schaltungstechnische Optimierung, beispielsweise zur Vergrößerung der Schaltspannung. Hierfür kann insbesondere die inhärente Mittenelektrode zwischen den beiden Speicherzellen A und B genutzt werden. Beispielsweise kann in die Reihenschaltung ein Serienwiderstand eingebaut werden. Eine Vergrößerung der Schaltspannung kann beispielsweise bei valenzwechselbasierten resistiven Speichern auf der Basis CMOS-kompatibler Materialien, wie etwa $Ta_2O_5$ oder $HfO_2$, sinnvoll sein, damit der resistive Speicher nicht ungewollt durch einen Lesezugriff seinen Zustand ändert.

Im Rahmen der Erfindung wurde ein weiteres nichtflüchtiges Speicherelement mit mindestens zwei stabilen Zuständen 0 und 1 entwickelt. Dieses umfasst erfindungsgemäß eine DRAM-Speicherzelle und

- mindestens eine mit dem Kondensator der DRAM-Speicherzelle in Reihe geschaltete resistive Speicherzelle, die die beiden Zustände 0 und 1 in einen Zustand HRS mit höherem elektrischem Widerstand und einen Zustand LRS mit niedrigerem elektrischem Widerstand kodiert, oder
- mindestens eine mit dem Kondensator der DRAM-Speicherzelle in Reihe geschaltete antiserielle Reihenschaltung zweier derartiger resistiver Speicherzellen A und B, die den Zustand 0 in der Zustandskombination A=LRS, B=HRS und den Zustand 1 in der Zustandskombination A=HRS, B=LRS kodiert.

Es wurde erkannt, dass der Kondensator der DRAM-Speicherzelle sich in besonderem Maße als Festkapazität für die Reihenschaltung mit einer resistiven Speicherzelle bzw. mit einer antiseriellen Reihenschaltung im Sinne der Erfindung eignet, insbesondere wenn er platzsparend als Trench-Struktur ausgeführt ist. Durch die Reihenschaltung mit der resistiven Speicherzelle bzw. mit der antiseriellen Reihenschaltung wird die bestehende DRAM-Struktur um Nichtflüchtigkeit bereichert; die Information ist dann nicht mehr im Kondensator der DRAM-Speicherzelle abgelegt, sondern im Zustand der resistiven Speicherzelle bzw. der antiseriellen Reihenschaltung.

Bei der Herstellung dieses nichtflüchtigen Speicherelements kann die bestehende DRAM-Struktur zur Gänze weiterverwendet werden. Es ist vorteilhaft, nicht nur den Kondensator, sondern auch den Transistor der DRAM-Speicherzelle weiterzuverwenden, da dieser das gezielte und ungestörte Ansprechen einer einzelnen Zelle auch in großen Arrays ermöglicht. Das Speicherelement eignet sich besonders zum kapazitiven Auslesen mittels des erfindungsgemäßen Verfahrens. Dies gilt insbesondere für eine besonders vorteilhafte Ausgestaltung der Erfindung, in der die antiserielle Reihenschaltung mit dem Kondensator und dem Auswahltransistor der DRAM-Speicherzelle in einer Reihe geschaltet ist. Speziell in dieser Ausgestaltung eignet sich das Speicherelement nicht nur für das kapazitive Auslesen, sondern kann in gleicher Weise angesteuert und betrieben werden wie eine herkömmliche DRAM-Zelle. Die beiden möglichen Zustände 0 und 1 der resistiven Speicherzelle werden dann gleichwohl über die unterschiedlichen Kapazitäten unterschieden, mit denen sie sich auf das letztendliche Ergebnis des Auslesens auswirken. Die resistive Speicherzelle wird also auch dann kapazitiv ausgelesen, wenn das Speicherelement als Ganzes wie eine herkömmliche DRAM-Zelle angesteuert und betrieben wird.

Die resistive Speicherzelle oder die antiserielle Reihenschaltung kann beispielsweise mit dem Kondensator der DRAM-Speicherzelle in Reihe geschaltet werden, indem sie als Schichtstruktur auf den Kondensator aufgebracht wird. Sie kann beispielsweise als planare Metall-Isolator-Metall-Struktur bei gleichbleibendem Platzbedarf ausgeführt werden.

In einer besonders vorteilhaften Ausgestaltung der Erfindung ist der Kondensator der DRAM-Speicherzelle als weitere resistive Speicherzelle ausgeführt. Das Speicherelement ist dann eine resistive Doppelzelle mit zwei Speicherzellen, deren Kapazitäten sich besonders stark voneinander unterscheiden. Damit ist es besonders gut zum kapazitiven Auslesen geeignet. Es ist außerdem besonders platzsparend aufgebaut und auf der Basis der bestehenden DRAM-Struktur einfach herzustellen. Um den Kondensator der DRAM-Speicherzelle zu einer resistiven Speicherzelle umzufunktionieren, genügt es, eines oder beide Elektrodenmaterialien und optional auch das Dielektrikum des Kondensators auszutauschen. Die durch den Kondensator gebildete resistive Speicherzelle kann insbesondere antiseriell zu der mit ihm in Reihe geschalteten resistiven Speicherzelle verschaltet sein.

In einer weiteren besonders vorteilhaften Ausgestaltung der Erfindung weist das Speicherelement einen dritten stabilen Zustand ON auf, der in der Zustandskombination A=LRS, B=LRS der antiseriellen Reihenschaltung kodiert ist. Auf der gleichen Fläche kann dann mehr als ein Bit an Information gespeichert werden. Hierfür ist das Speicherelement idealerweise kapazitiv auslesbar ausgestaltet im Sinne des deutschen Patents 10 2011 012 738, d.h. die beiden Speicherzellen A und B haben unterschiedliche Kapazitäten. Es können dann drei Kapazitätswerte unterschieden werden:

• Zustand 0: wegen A=LRS ist die Kapazität von A überbrückt, die Kapazität der Reihenschaltung wird durch die Kapazität von B bestimmt;
• Zustand 1: wegen B=LRS ist die Kapazität von B überbrückt, die Kapazität der Reihenschaltung wird durch die Kapazität von A bestimmt;
• Zustand ON: wegen A=LRS und B=LRS ist die Kapazität der Reihenschaltung insgesamt überbrückt, so dass die Gesamtkapazität des Speicherelements nur noch durch die Kapazität des DRAM-Kondensators bestimmt wird.

Spezieller Beschreibungsteil

Nachfolgend wird der Gegenstand der Erfindung anhand von Figuren erläutert, ohne dass der Gegenstand der Erfindung hierdurch beschränkt wird. Es ist gezeigt:

Figur 1: Ausbau einer DRAM-Struktur zum erfindungsgemäßen Speicherelement.
Figur 2: Ausbau eines MOSFET zum erfindungsgemäßen Speicherelement.

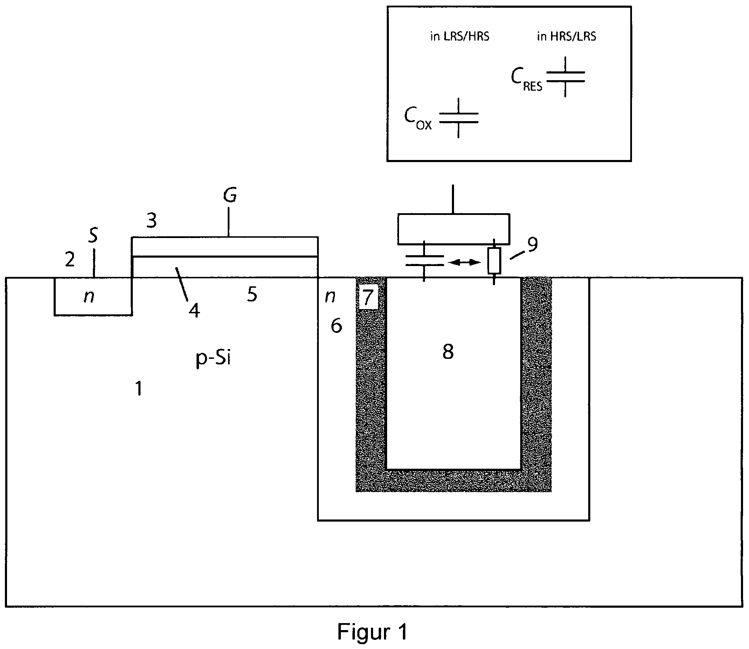

Figur 1 zeigt schematisch den Aufbau eines erfindungsgemäßen Speicherelements, das als Reihenschaltung einer DRAM-Speicherzelle mit einer resistiven Speicherzelle realisiert wurde. In ein Substrat 1 aus p-dotiertem Silizium ist der Transistor der DRAM-Zelle mit n-dotiertem Sourcegebiet 2, einem Gate 3, das durch ein Gatedielektrikum 4 vom p-dotierten Kanal 5 isoliert ist, und n-dotiertem Draingebiet 6 eingebracht. Zur Herstellung des Draingebiets 6 wurde zunächst ein Graben in das Substrat 1 eingebracht und die Wand dieses Grabens anschließend nachträglich n-dotiert. Der Kanal 5 wird bei Anlegen einer Spannung zwischen Source 2 und Gate 3 n-leitend, was den Transistor einschaltet.

Auf die das Draingebiet 6 bildende Grabenwand wurde $SiO_2$ als Dielektrikum 7 aufgebracht, das auch durch ein anderes Dielektrikum ersetzt werden kann. Sodann wurde der Graben mit n-dotiertem Silizium 8 aufgefüllt, das auch durch ein Metall ersetzt werden kann. Dieses Silizium 8 sowie das Draingebiet 6 sind die Platten des Kondensators der DRAM-Zelle, die durch das Dielektrikum 7 gegeneinander isoliert sind.

Auf das Silizium 8 ist nun eine resistive Speicherzelle 9 aufgebracht. Diese ist mit dem Kondensator (6; 7; 8) in Reihe geschaltet. Die Gesamtkapazität dieser Reihenschaltung hängt vom Widerstand der Speicherzelle und damit von ihrem Speicherzustand ab: Ist die Speicherzelle niederohmig (Zustand 1), ist ihre Kapazität überbrückt, und für die Gesamtkapazität ist nur noch die erheblich größere Festkapazität des Kondensators (6; 7; 8) maßgeblich. Ist die Speicherzelle hochohmig, wirkt ihre Kapazität mit der Festkapazität zusammen.

Der Kondensator (6; 7; 8) lässt sich ebenfalls als resistive Speicherzelle ausgestalten, indem die Schichtdicken der Elektroden (6; 8) und des Dielektrikums 7 passend gewählt werden. Dann ist das Speicherelement zum Einen nach wie vor eine Reihenschaltung aus dem Kondensator (6; 7; 8) und der Speicherzelle 9. Zum Anderen ist es eine gleichzeitig resistive Doppelzelle, also eine Reihenschaltung aus zwei resistiven Speicherzellen. Befindet sich das Speicherelement im Zustand 0, wird das auf der Ebene der Speicherzellen dergestalt repräsentiert, dass die Speicherzelle 9 sich im Zustand 0 (hochohmig) befindet, während die Speicherzelle (6; 7; 8) sich im Zustand 1 (niederohmig) befindet (Zustand HRS/LRS). Maßgeblich für die Gesamtkapazität ist dann die Kapazität $C_{RES}$ der Speicherzelle 9. Befindet sich das Speicherelement umgekehrt im Zustand 1, wird das auf der Ebene der Speicherzellen dergestalt repräsentiert, dass die Speicherzelle 9 sich im Zustand 1 (niederohmig) befindet, während die Speicherzelle (6; 7; 8) sich im Zustand 0 (hochohmig) befindet (Zustand LRS/HRS). Maßgeblich für die Gesamtkapazität ist dann die Kapazität $C_{OX}$ der Speicherzelle (6; 7; 8), die wesentlich größer ist als die Kapazität $C_{RES}$ der Speicherzelle 9. Über den Unterschied in den Gesamtkapazitäten lassen sich die beiden Zustände 0 und 1 des Speicherelements voneinander unterscheiden.

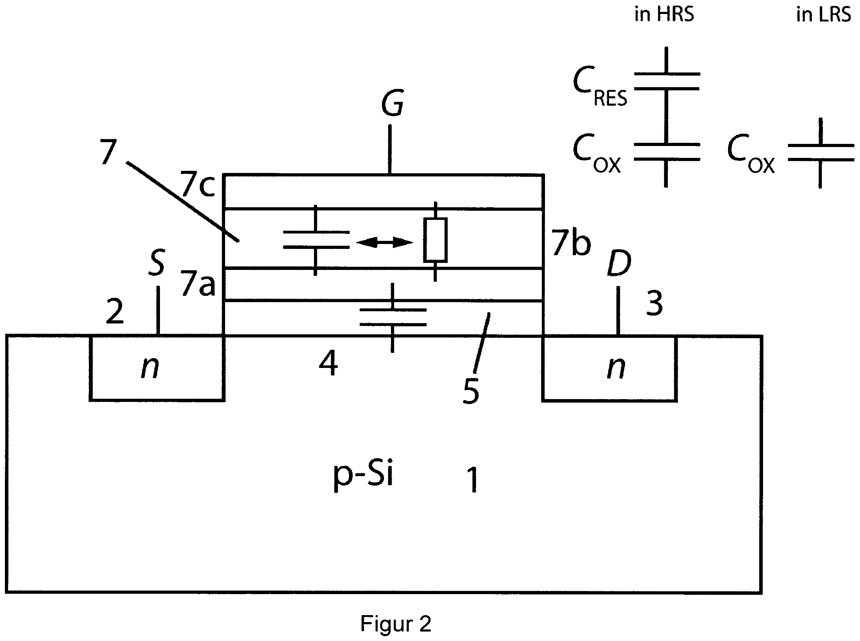

Figur 2 zeigt schematisch den Aufbau eines erfindungsgemäßen Speicherelements, bei dem die Festkapazität das Gatedielektrikum eines MOSFET umfasst. Der MOSFET ist aus einem Substrat 1 aus p-dotiertem Silizium gefertigt, in dem ein Sourcegebiet 2 und ein Draingebiet 3 jeweils n-dotiert wurden. Diese n-Dotierung lässt sich nachträglich am p-Substrat vornehmen, ohne dass Material physisch entfernt und durch n-dotiertes Material ersetzt werden muss. Zwischen dem Sourcegebiet 2 und dem Draingebiet 3 befindet sich der p-dotierte Kanal 4, der vom Gatedielektrikum 5 bedeckt ist. Auf das Gatedielektrikum ist nun an Stelle der herkömmlichen Gateelektrode eine resistive Speicherzelle 7 aufgebracht. Dieses ist in planarer MIM (Metall-Isolator-Metall) Technik gefertigt und umfasst eine untere Elektrode 7a, die an das Gatedielektrikum angrenzt, ein Dielektrikum 7b und eine obere Elektrode 7c. Die untere Elektrode 7a, das Gatedielektrikum 5 und das Substrat 1 mit dem Kanal 4 bilden die Festkapazität $C_{OX}$, die wiederum mit der Speicherzelle 7 in Reihe geschaltet ist. Ist die Speicherzelle im Zustand 0 (hochohmig, HRS), wirkt ihre Kapazität $C_{RES}$ mit dieser Festkapazität $C_{OX}$ zusammen; ist sie im Zustand 1 (niederohmig, LRS), ist ihre Kapazität $C_{RES}$ überbrückt, und die Gesamtkapazität wird durch die Festkapazität $C_{OX}$ bestimmt. Der Kanal 4 wird bei Anlegen einer Spannung zwischen Source 2 und unterer Elektrode 7a der Speicherzelle n-leitend, was den Transistor einschaltet.

## Patentansprüche

1. Nichtflüchtiges nichtdestruktiv kapazitiv auslesbares Speicherelement mit mindestens zwei stabilen Zuständen 0 und 1, umfassend eine DRAM-Speicherzelle welche einen Kondensator (6, 7, 8) mit Festkapazität aufweist,

   a) mindestens eine mit dem Kondensator der DRAM-Speicherzelle in Reihe geschaltete resistive Speicherzelle (9), die die beiden Zustände 0 und 1 in einen Zustand HRS mit höherem elektrischem Widerstand und einen Zustand LRS mit niedrigerem elektrischem Widerstand kodiert, oder
   b) mindestens eine mit dem Kondensator der DRAM-Speicherzelle in Reihe geschaltete antiserielle Reihenschaltung zweier derartiger resistiver Speicherzellen (9) A und B, die den Zustand 0 in der Zustandskombination A=LRS, B=HRS und den Zustand 1 in der Zustandskombination A=HRS, B=LRS kodiert,

   dadurch gekennzeichnet, dass die resistive Speicherzelle (9) oder die antiseriel-Reihenschaltung als Schichtstruktur auf den Kondensator der DRAM-Speicherzelle aufgebracht ist, und dass der Kondensator der DRAM-Speicherzelle als weitere resistive Speicherzelle (9) ausgeführt ist indem Schichtdicken von Elektroden und Dielektrikum des Kondensators der DRAM-Speicherzelle passend gewählt sind.

2. Nichtflüchtiges nichtdestruktiv kapazitiv auslesbares Speicherelement nach Anspruch 1, dadurch gekennzeichnet, dass die resistive Speicherzelle (9) oder die antiserielle Reihenschaltung mit dem Kondensator und einem Auswahltransistor (2, 3, 4, 5, 6) der DRAM-Speicherzelle in einer Reihe geschaltet ist.

3. Nichtflüchtiges nichtdestruktiv kapazitiv auslesbares Speicherelement nach einem der Ansprüche 1, Alternative b) oder 2, dadurch gekennzeichnet, dass es einen dritten stabilen Zustand ON aufweist, der in der Zustandskombination A=LRS, B=LRS der antiseriellen Reihenschaltung kodiert ist, so dass die Gesamtkapazität des Speicherelements nur noch durch die Festkapazität des Kondensators der DRAM-Speicherzelle bestimmt ist.

## Claims

1. A non-volatile non-destructive capacitively readable memory elements with at least two stable states 0 and 1, comprising a DRM memory cell which has a capacitor (6, 7, 8) with residual capacity.

   a) at least on resistive memory cell (9) connected in series to the capacitor of the DRAM memory cell, which memory cell (9) codes the two states 0 and 1 into an HRS state with a higher electrical resistance, or into an LRS state with a lower electrical resistance, or
   b) at least one antiseriaes series connection of two such resistant memory cells (9) A and B, connected in series to the capacitor of the DRAM memory cell, which memory cell codes the state 0 in the state combination A=LRS, B=HRS and state 1 in the state combination A=HRS, B=LRS,

   characterised in that the resistive memory cell (9) or the antiseries series connection is installed as a layer structure is installed on the capacitor of the DRAM memory cell and in that the capacitor of the DRAM memory cell is designed as a further resistive memory cell (9), layer thicknesses memory cell being suitably chosen.

2. The non-volatile non-destructive capacitive readable memory element according to Claim 1, characterised in that the resistive memory cell (0) or the antiseries series connection to the capacitor and a selection transistor (2, 3, 4, 5, 6) of the DRAM memory cell in series connected.

3. The non-volatile non-destructive capacitive readable memory element according to any one of Claims 1, alternative b) or 2,
**characterised in that** it has a third stable state ON, which is coded in the state combination A=LRS, B=LRS of the antiseries serial connection so that the total capacitance of the memory cell is determined only by the residual capacity of the capacitor of the DRAM memory cell.

## Revendications

1. Elément de mémoire non-volatil, non-destructif et déchiffrable capacitivement ayant au moins deux états stables 0 et 1, comprenant une cellule de mémoire DRAM, qui a un condensateur (6, 7, 8) de capacité fixe,

    a) au moins une cellule (9) de mémoire résistive, qui est montée en série avec le condensateur de la cellule de mémoire DRAM et qui code les deux états 0 et 1 dans un état HRS de grande résistance électrique et dans un état LRS de petite résistance électrique ou
    b) au moins, monté en série avec le condensateur de la cellule de mémoire DRAM, un circuit série tête-bêche de deux cellules (9) de mémoire résistives A et B, telles qu'il code l'état 0 dans la combinaison d'état A=LRS, B=HRS et l'état 1 dans la combinaison d'état A=HRS, B=LRS,

    **caractérisé en ce que** la cellule (9) de mémoire résistive ou le circuit série tête-bêche est déposé sous la forme d'une structure en couche sur le condensateur de la cellule de mémoire DRAM et **en ce que** le condensateur de la cellule de mémoire DRAM est réalisé sous la forme d'une autre cellule de mémoire résistive par le fait que des épaisseurs de couche d'électrodes et de diélectrique du condensateur de la cellule de mémoire DRAM sont choisies de manière adaptée.

2. Elément de mémoire non-volatil, non-destructif et déchiffrable capacitivement suivant la revendication 1, **caractérisé en ce que** la cellule (9) de mémoire résistive ou le circuit-série tête-bêche est monté en série avec le condensateur et avec un transistor (2, 3, 4, 5, 6) de sélection de la cellule de mémoire DRAM.

3. Elément de mémoire non-volatil, non-destructif et déchiffrable capacitivement suivant l'une des revendications 1, variante b) ou 2, **caractérisé en ce qu'**il a un troisième état stable ON, qui est codé dans la combinaison d'état A=LRS, B=LRS du circuit série tête-bêche, de manière à ne définir la capacité d'ensemble de l'élément de mémoire que par la capacité fixe du condensateur de la cellule de mémoire DRAM.

Figur 1

Figur 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009023153
- DE 102011012738
- US 20070035990 A1
- US 20060120138 A1